# EUROPÄISCHE PATENTSCHRIFT

(11) **EP 1 064 685 B1**
(45) Veröffentlichungstag und Bekanntmachung des Hinweises auf die Patenterteilung: **08.08.2007**
(21) Anmeldenummer: 99919112.5
(22) Anmeldetag: 12.03.1999
(51) Int. Cl.: H01L 31/18, H01L 21/368

(54) **VERFAHREN UND ANORDNUNG ZUR HERSTELLUNG DÜNNER METALLCHALKOGENID-SCHICHTEN**
METHOD AND ARRANGEMENT FOR PRODUCING THIN METAL CHALCOGENIDE LAYERS
PROCEDE ET DISPOSITIF POUR PRODUIRE DES COUCHES MINCES DE CHALCOGENURE METALLIQUE

(30) Priorität: 19.03.1998 DE 19813154; 03.07.1998 DE 19831214
(43) Veröffentlichungstag der Anmeldung: 03.01.2001
(73) Patentinhaber: Hahn-Meitner-Institut Berlin Gesellschaft mit beschränkter Haftung, 14109 Berlin (DE)
(72) Erfinder: FISCHER, Christian, D-14169 Berlin (DE); MÖLLER, Jesco, D-44139 Dortmund (DE); KÖNENKAMP, Rolf, D-32257 Bünde (DE); LUX-STEINER, Martha, Christina, D-14163 Berlin (DE); SIEBENTRITT, Susanne, L-2563 Luxembourg (LU)
(74) Vertreter: Rudolph, Margit
(86) Internationale Anmeldenummer: PCT/DE1999/000811
(87) Internationale Veröffentlichungsnummer: WO 1999/048158

(56) Entgegenhaltungen:
- FR-A- 2 454 473
- BECK M E ET AL: "THIN-FILM COPPER INDIUM DISELENIDE PREPARED BY SELENIZATION OF COPPER INDIUM OXIDE FORMED BY SPRAY PYROLYSIS" THIN SOLID FILMS, Bd. 272, Nr. 1, 1. Januar 1996 (1996-01-01), Seiten 71-82, XP000623629 ISSN: 0040-6090
- PENCE S ET AL: "MORPHOLOGICAL FEATURES IN FILMS OF CDS PREPARED BY CHEMICAL SPRAY PYROLYSIS" MATERIALS LETTERS, Bd. 23, Nr. 4/06, 1. Mai 1995 (1995-05-01), Seiten 195-201, XP000512257 ISSN: 0167-577X
- DATABASE INSPEC [Online] INSTITUTE OF ELECTRICAL ENGINEERS, STEVENAGE, GB DAWNAY E J C ET AL: "Growth and characterization of semiconductor nanoparticles in porous sol-gel films" Database accession no. 5797556 XP002110743 & JOURNAL OF MATERIALS RESEARCH, NOV. 1997, MATER. RES. SOC, USA, Bd. 12, Nr. 11, Seiten 3115-3126, ISSN: 0884-2914
- DATABASE INSPEC [Online] INSTITUTE OF ELECTRICAL ENGINEERS, STEVENAGE, GB TANAHASHI I ET AL: "Preparation and optical properties of CdS-microcrystallites deposited in porous Vycor glass" Database accession no. 4601345 XP002110744 & JOURNAL OF THE CERAMIC SOCIETY OF JAPAN, AUG. 1993, JAPAN, Bd. 101, Nr. 8, Seiten 850-854, ISSN: 0914-5400
- DULTSEV F N ET AL: "Formation of nanoclusters during the interaction of H2S with cadmium, zinc and copper behenates" THIN SOLID FILMS, Bd. 288, Nr. 1, 15. November 1996 (1996-11-15), Seite 103-107 XP004049531 ISSN: 0040-6090
- S. SIEBENTRITT, K. ERNST, CH.-H. FISCHER, R. KÖNENKAMP, M. C. LUX-STEINER: "CdTe and CdS as extremely thin absorber materials in an eta solar cell" PROCEEDINGS OF THE 14TH EUROPEAN PHOTOVOLTAIC SOLAR ENERGY CONFERENCE, 30. Juni 1997 (1997-06-30) - 4. Juli 1997 (1997-07-04), Seiten 1823-1826, XP002110737 Barcelona
- TAKAHIRO WADA ET AL: "PREPARATION OF CUINS2 FILMS BY SULFURIZATION OF CU-IN-O FILMS" APPLIED PHYSICS LETTERS, Bd. 62, Nr. 16, 19. April 1993 (1993-04-19), Seiten 1943-1945, XP000359648 ISSN: 0003-6951
- J. MÖLLER, CH.-H. FISCHER, S. SIEBENTRITT, R. KÖNENKAMP, M. CH. LUX-STEINER: "CuInS2 and extremely thin absober in an eta solar cell" CONFERENCE PROCCEDINGS OF THE 2ND WORLD CONFERENCE AND EXHIBITION ON PHOTOVOLTAIC SOLAR ENERGY CONVERSION, 6. - 10. Juli 1998, Seiten 209-211, XP002110735 Vienna

## Beschreibung

Die Erfindung betrifft ein Verfahren und eine Anordnung zur Herstellung dünner Metallchalkogenid-Schichten gemäß den jeweiligen Ansprüchen 1 und 15 beispielsweise für den Einsatz als Absorber- bzw. Pufferschichten in Solarzellen.

Zur Herstellung von Metallchalkogenidschichten in einem einzigen Verfahrensdurchlauf sind aus den Aufsätzen (1) "Thin-film copper indium diselenide perpared by selenization of copper indium oxide formed by spray pyrolysis" (M. E. Beck et al., Thin Solid Films 272 (1996) 71-82) und (II) "Morphological features in films of CdS perpared by chemical spray pyrolysis" (S. Pence et al., Material Letters 23 (1995) 915-201) sowie aus der französichen Patentanmeldung (III) N° 80 08685 sogenannte "Spraypyrolyseverfahren" mit einem hohen Energieeinsatz und einem zweistufigen Reaktionsablauf bekannt. Bei den in den Veröffentlichungen (I) und (III) beschriebenen Verfahren wird im ersten Reaktionsschritt eine Metallsalzlösung auf ein heißes Substrat aufgesprüht, um eine Metalloxidschicht herzustellen (Pyrolyse). Diese wird dann in einem zweiten Reaktionsschritt thermisch mit einem Chalkogen (I) oder Chalkogenwasserstoff (III) in ein anderes Metallchalkogenid umgewandelt. Das Ausgangsprodukt (Metalloxid) für die Umsetzung zum Endprodukt (Metallchalkogenid) wird also in einem vorgeschalteten Reaktionsschritt erzeugt, der die geregelte Zufuhr von thermischer Energie in größerem Umfang erfordert. In dem Verfahren gemäß Aufsatz (I) wird darüberhinaus elementares Selen als chalkogenhaltiger Reaktionspartner eingesetzt. Bei dem aus dem Aufsatz (II) bekannten Verfahren wird eine Lösung aus Metallsalz und Thiohamstoff auf ein heißes Substrat gesprüht. Dadurch erfolgt wiederum eine thermische Reaktion (Pyrolyse), die zunächst aus dem Thiohamstoff eine reaktive Schwefelspezies erzeugt, die dann mit dem Metallsalz reagiert.

Weiterhin wird zur Erzeugung von Schichten aus schwer löslichen Metallchalkogeniden bisher häufig das Verfahren der chemischen Badabscheidung (chemical bath deposition, CBD) eingesetzt. Hiervon sind zwei unterschiedliche Varianten bekannt.

Im sogenannten SILAR-Verfahren (Successive Ionic Layer Adsorption and Reaction) wird ein Substrat nacheinander in Lösungen eines Metallsalzes und eines gut löslichen Chalkogenids getaucht. Zweckmäßigerweise erfolgt nach jedem Bad eine Spülung des Substrats. Die an der Oberfläche des Substrats im ersten Bad adsorbierten Metallionen reagieren mit den Chalkogenidionen im 2. Bad zu einem schwer löslichen Metallchalkogenid. Dieser Behandlungszyklus wird bis zum Erreichen der gewünschten Schichtdicke wiederholt (vgl. M.P. Valkonen, T. Kanniainen, S. Lindros, M. Leskelä, E. Rauhala; Applied Surface Science, 115 (1997) S. 386-392). Nachteilig ist bei diesem Verfahren die mangelnde Gleichmäßigkeit (Homogenität) der Metallchalkogenid-Schicht. Insbesondere bei Substraten mit porösen Oberflächen zeigt sich eine ausgeprägte Krustenbildung der aufgebrachten Schicht.

Beim Chalkogeno-Hamstoffverfahren wird in einem Bad eines gelösten Metallsalzes bzw. Metallkomplexes Chalkogeno-Harnstoff thermisch zersetzt. Dabei werden Chalkogenidionen freigesetzt, die mit dem an der Oberfläche des eingetauchten Substrats adsorbierten Metallionen reagieren unter Bildung eines schwer löslichen Metallchalkogenids (s. T.M. Friedelmeier, D. Braunger, D. Hariskos, M. Kaiser, H.M. Wanka, H.W. Schock; Proceedings 25th PVSC, May 13.-17, 1996, Washington D.C., USA, S. 845-848). Nachteilig ist hierbei, daß sich der Prozeß der Metallchalkogenidbildung nicht nur auf der Substratoberfläche sondern in der gesamten Lösung vollzieht. Diese ist daher schon nach einem Durchlauf nicht mehr verwendbar, obwohl für die Beschichtung des Substrats nur ein sehr geringer Teil der Lösung genutzt worden ist. Weiterhin fordert das Verfahren eine sehr genaue Temperaturführung, und die Qualität der Beschichtung ist sehr stark von der Qualität des eingesetzten Chalkogeno-Harnstoffes abhängig. So können z.B. unterschiedliche Chargen von Chalkogeno-Harnstoff des gleichen Herstellers durchaus zu Schichten sehr unterschiedlicher Qualität führen. Die Ursachen für diese Qualitätsschwankungen konnten bisher noch nicht geklärt werden.

Der Erfindung liegt daher die Aufgabe zugrunde, ein Verfahren und eine Anordnung anzugeben zur einfachen Herstellung homogener Metallchalkogenid-Schichten in gleichbleibender Qualität unter Beachtung ökonomischer und ökologischer Gesichtspunkte.

Die Aufgabe wird erfindungsgemäß durch die Angabe eines Verfahrens mit nachstehend aufgeführten Verfahrensschritten gelöst:
1. Aufbringen einer Lösung einer Metallverbindung auf ein Substrat zur Adsorption von Metallionen,
2. Feuchtigkeitsentzug aus dem Substrat mit den an dessen Oberfläche adsorbierten Metallionen,
3. Einleitung eines chalkogenwasserstoffhaltigen Gases zur Reaktion mit den adsorbierten Metallionen.

Das Aufbringen der Lösung der Metallverbindung auf das Substrat kann in vorteilhafter Weise durch Aufsprühen oder auch durch Tauchen des Substrats in die Lösung erfolgen.

Als Substrat können beispielsweise TiO₂, CulnS₂, CuGaSe₂, Chalkopyrite allgemein oder Glas eingesetzt werden.

Als Lösung einer Metallverbindung werden gelöste Verbindungen von Metallen wie Cd, Cu, In, Pb, Ag, Sb oder Bi einzeln oder Mischungen davon eingesetzt, die in Reaktion mit Chalkogenwasserstoffen schwer lösliche Metallchalkogenide bilden.

Die Metallverbindungen werden im Regelfalle in einem leicht flüchtigen Lösungsmittel, wie Methanol, Ethanol, Acetonitril oder Mischungen davon gelöst. Bei einigen Metallverbindungen, wie z.B. solchen die Indium enthalten, kann auch Wasser als Lösungsmittel eingesetzt werden. Die Verwendung von Wasser als Lösungsmittel ist besonders dann angebracht, wenn ein Substrat mit einer definierten Restfeuchte für die Chalkogenisierung der adsorbierten Metallionen eingesetzt werden soll.

Entsprechend der unterschiedlichen Reaktionsfähigkeit der jeweils für die Chalkogenidbildung eingesetzten Metalle wird das Temperaturregime für den Verfahrensablauf unterschiedlich festgelegt. Die optimale Verfahrenstemperatur kann daher auch oberhalb oder unterhalb der üblichen Raumtemperatur liegen.

Für den Feuchtigkeitsentzug kann eine nachgeschaltete Trocknung in einem Gasstrom aus Inertgasen wie z.B. Edelgasen oder molekularem Stickstoff eingesetzt werden.

Der Feuchtigkeitsentzug kann auch durch Verdunstung des Lösungsmittels bis zu einer definierten Restfeuchte des Substrats erfolgen. Dabei kann die Verdunstung auch bei einer Zwischenlagerung des mit Metallionen bedeckten Substrats bzw. beim Transport des Substrats erfolgen.

Das Reaktionsgas für die Reaktion mit den adsorbierten Metallionen enthält die Wasserstoffverbindungen der Chalkogene S, Se oder Te. Nachfolgend kann zweckmäßigerweise eine Spülung für das beschichtete Substrat in einem Lösungsmittel, vorzugsweise Methanol, zur Entfernung überschüssiger Reaktionsprodukte und u.U. eine Trocknung vorgesehen sein.

Die erreichbaren Schichtdicken liegen in einem Variationsbereich von monomolekular bis zum µ-Bereich. Je nach gewünschter Schichtdicke wird der Verfahrenszyklus entsprechend oft wiederholt.

Gegenüber den vorstehend beschriebenen bekannten Verfahren weist das erfindungsgemäße Verfahren die nachstehend aufgeführten Vorteile auf:
1. Es ist generell unempfindlich gegen Variationen der Prozeß-Parameter.
2. Die eingesetzten Metallsalze können vollständig ausgenutzt werden statt weniger Prozente beim Chalkogeno-Harnstoffverfahren. Damit ist das erfindungsgemäße Verfahren ökonomischer und auch ökologischer (insbesondere bei toxischen Ausgangsstoffen wie z.B. Kadmiumsalzen).
3. Es erfolgt kein Einbau von Hydroxiden, wenn die Reaktion in einem sauren Milieu abläuft.
4. Bei Beschichtung von porösen Substraten ergibt sich ein homogener Schichtaufbau ohne Krustenbildung.
5. Der Verfahrensablauf läßt sich ohne großen Aufwand automatisieren.
6. Das erfindungsgemäße Verfahren ist prinzipiell für alle schwer löslichen Chalkogenide einsetzbar.

Die Anordnung zur Durchführung des erfindungsgemäßen Verfahrens, die einen in allen drei Ebenen beweglichen Substrathalter, ein Bad einer gelösten Metallverbindung, ein Trockengefäß, ein Reaktionsgefäß sowie ein Spülbad aufweist, ist am Substrathalter mit einer Abdeckung versehen, die nach Einbringen des Substrats in das Reaktionsgefäß durch Absenken des Substrathalters für einen gasdichten Verschluß des Reaktionsgefäßes sorgt.

Die Erfindung wird nachstehend an Anwendungsbeispielen für das Verfahren und einer Ausführungsform der Anordnung anhand der zugehörigen Zeichnung näher erläutert:

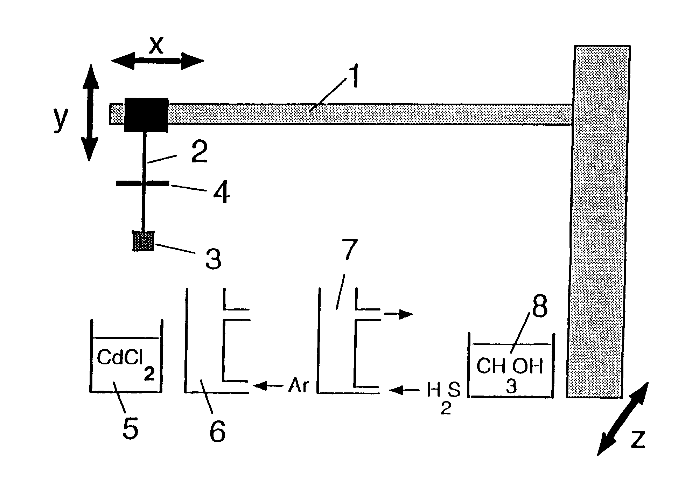

Die Zeichnung zeigt in schematischer Darstellung eine Anordnung zur automatischen Abscheidung von Metallchalkogenid-Schichten nach dem erfindungsgemäßen Verfahren.

In ein Metallsalzbad von in 90 %igem Methanol gelösten CdCl₂ wird ein extrem poröses TiO₂-Substrat eingebracht. Die Verweildauer beträgt ca. 20 sec. In dieser Zeit sind genügend Cd-lonen an der Substratoberfläche adsorbiert worden. Es folgt eine rasche Trocknung (max. 2 min) in einem Argongasstrom und anschließend die Reaktion in einem H₂S-haltigen Gasstrom. Die Reaktionszeit beträgt ca. 10 - 20 sec. Während dieser Zeit erfolgt die Bildung von CdS aus den an der TiO₂-Oberfläche adsorbierten Cd-Ionen. Nachgeschaltet ist eine Spülung in einem Methanolbad zur Entfernung überschüssiger Reaktionsprodukte. Eine abschließende Trocknung in einem Argongasstrom bei hoher Gasgeschwindigkeit ist nicht unbedingt erforderlich.

Der gesamte Verfahrensablauf erfolgt bei Raumtemperatur und bei Normaldruck. Es sind daher keine Temperaturregelung und druckdichten Gefäße erforderlich. Je nach gewünschter Schichtdicke kann der Verfahrenszyklus beliebig oft wiederholt werden. SEM-Aufnahmen der erzielten CdS-Schichten zeigten praktisch keinen Unterschied zur Reliefstruktur der unbeschichteten Substrate, d.h. die Beschichtung folgt extrem genau in gleichbleibender Stärke dem feinstrukturierten Oberflächenrelief der Substrate. Im Gegensatz zum konventionellen SILAR-Verfahren wurde keine Krustenbildung beobachtet. Analog zum vorstehend beschriebenen Verfahrensablauf erfolgte die Herstellung einer Cu(I)-Sulfidschicht auf einem extrem porösen TiO₂-Substrat. Diese Schichten sind als Absorber in einer eta (extremely thin absorber)-Solarzelle vorgesehen.

Mit dem erfindungsgemäßen Verfahren können auch Einzelschichten aus CuₓS und In₂S₃ sequentiell auf ein Substrat aufgebracht werden, die durch einen nachgeschalteten Temperprozeß in CulnS₂ umgewandelt werden.

In weiterer Anwendung des erfindungsgemäßen Verfahrens wurden für CulnS₂-Solarzellen mit den vorstehend genannten Verfahrensparametern Pufferschichten aus CdS auf die Absorberschicht aufgebracht.

Die automatische Durchführung des erfindungsgemäßen Verfahrens wurde mit der nachstehend beschriebenen Anordnung erreicht.

Ein mittels einer Führung **1** in allen drei Ebenen beweglicher Substrathalter **2** mit einem Substrat **3** ist mit einer Abdeckung **4** versehen. Im CdCl₂-Lösungsbad **5** erfolgt die Adsorption von Cd-lonen an der Substratoberfläche. Das nachgeschaltete Trocknungsgefäß **6** dient der Trocknung mittels Argon. Im anschließenden Reaktionsgefäß **7** erfolgt die CdS-Bildung durch Einleitung von H₂S. Hierbei wird nach Einbringen des Substrats **3** das Reaktionsgefäß **7** durch die am Substrathalter **2** angebrachte Abdeckung **4** gasdicht verschlossen. Hierdurch ist ein Entweichen des stark toxischen H₂S-Gases in die Umgebungsluft nicht mehr möglich. Die Zuführung von H₂S-Gas setzt erst ein, wenn das Reaktionsgefäß **7** gasdicht verschlossen ist und die Absaugpumpe eingeschaltet ist. Nach dem Reaktionsgefäß **7** folgt das Spülbad **8**. Hier werden mittels Methanol die überschüssigen Reaktionsprodukte ausgewaschen.

## Patentansprüche

1. Verfahren zur Herstellung dünner Metallchalkogenid-Schichten beispielsweise für den Einsatz als Absorber- bzw. Pufferschichten in Solarzellen in nachstehend aufgeführten Verfahrensschritten bei Normaldruck, wobei entsprechend der unterschiedlichen Reaktionsfähigkeit der jeweils für die Chalkogenidbildung eingesetzten Metalle das Temperaturregime für den Verfahrensablauf unterschiedlich festgelegt wird:
• Aufbringen einer Lösung einer Metallverbindung auf ein Substrat zur Adsorption von Metallionen ohne Eintritt einer chemischen Reaktion,
• Feuchtigkeitsentzug aus dem Substrat mit den adsorbierten Metallionen,
• Einleitung eines chalkogenwasserstoffhaltigen Gases zur Reaktion mit den adsorbierten Metallionen,
wobei die Verfahrenschritte bis zum Erreichen einer gewünschten Schichtdicke zyklisch wiederholt werden.

2. Verfahren nach Anspruch 1,
**dadurch gekennzeichnet, daß**
das Aufbringen der Lösung einer Metallverbindung auf das Substrat durch Aufsprühen erfolgt.

3. Verfahren nach Anspruch 1,
**dadurch gekennzeichnet, daß**
das Aufbringen der Lösung einer Metallverbindung durch Tauchen des Substrats in diese Lösung erfolgt.

4. Verfahren nach Anspruch 1,
**dadurch gekennzeichnet, daß**
als Substrat TiO₂, CulnS₂, CuGaSe₂, Chalkopyrite allgemein oder Glas eingesetzt werden.

5. Verfahren nach Anspruch 1,
**dadurch gekennzeichnet, daß**
als Lösung einer Metallverbindung gelöste Verbindungen von Metallen wie Cd, Cu, In, Pb, Ag, Sb oder Bi einzeln oder Mischungen davon eingesetzt

6. Verfahren nach Anspruch 1,
**dadurch gekennzeichnet, daß**
die Metallverbindung in einem leicht flüchtigen Lösungsmittel gelöst ist.

7. Verfahren nach Anspruch 6,
**dadurch gekennzeichnet, dass**
als Lösungsmittel Methanol, Ethanol, Acetonitril oder Mischungen davon eingesetzt werden.
werden, die in Reaktion mit Chalkogenwasserstoffen schwer lösliche Metallchalkogenide bilden.

8. Verfahren nach Anspruch 1,
**dadurch gekennzeichnet, daß**
die Metallverbindung in Wasser gelöst ist.

9. Verfahren nach Anspruch 1,
**dadurch gekennzeichnet, daß**
der Feuchtigkeitsentzug durch Trocknung in einem Gasstrom, vorzugsweise von inertgasen wie z.B. Edelgasen oder molekularem Stickstoff erfolgt.

10. Verfahren nach Anspruch 1 und 8,
**dadurch gekennzeichnet, daß**
der Feuchtigkeitsentzug durch Verdunstung bis zu einer definierten Restfeuchte des Substrats erfolgt.

11. Verfahren nach Anspruch 10,
**dadurch gekennzeichnet, daß**
die Verdunstung bei der Zwischenlagerung des mit Metallionen bedeckten Substrats bzw. beim Transport desselben erfolgt.

12. Verfahren nach Anspruch 1,
**dadurch gekennzeichnet, daß**
das Reaktionsgas die Wasserstoffverbindungen der Chalkogene S, Se oder Te enthält.

13. Verfahren nach Anspruch 1,
**dadurch gekennzeichnet, daß**
im Anschluss an die Reaktion eine Spülung des beschichteten Substrats in einem Lösungsmittelbad, vorzugsweise Methanol, zur Entfernung überschüssiger Reaktionsprodukte erfolgt.

14. Verfahren nach Anspruch 13,
**dadurch gekennzeichnet, daß**
der Spülung eine Trocknung nachgeschaltet ist.

15. Anordnung zur Durchführung des Verfahrens nach Anspruch 1 bis 12 mit einem Substrathalter, einem abdeckbaren Reaktionsgefäß und einem Gefäß mit einer gelösten Metallverbindung,
**dadurch gekennzeichnet, dass**
das Gefäß mit der gelösten Metallverbindung als Tauchbad (5) ausgebildet ist, neben dem Tauchbad (5) ein von einem Gasstrom durchströmbares Trockengefäß (6) angeordnet ist und neben dem Trockengefäß (6) ein Spülbad (8) angeordnet ist, wobei Tauchbad (5), Trockengefäß (6), Reaktionsgefäß (7) und Spülbad (8) nach oben offen ausgebildet sind, und dass der Substrathalter (2) in allen Ebenen beweglich ausgebildet ist und von oben in Tauchbad (5), Trockengefäß (6), Reaktionsgefäß (7) und Spülbad (8) eingefahren werden kann, wobei eine Abdeckung (4) direkt mit dem Substrathalter (2) fest verbunden ist und im eingefahrenen Zustand des Substrathalters (2) das Reaktionsgefäß (7) gasdicht verschließt.

## Claims

1. Method of producing thin metal chalcogenide films for use for example as absorber or buffer layers in solar cells, in the process steps set out below under normal pressure, the temperature regime for the procedure being defined differently according to the differing reactivity of the metals used for chalcogenide formation:
• Application of a solution of a metal compound to a substrate for the purpose of adsorption of metal ions without the occurrence of a chemical reaction,
• Removal of moisture from the substrate with the adsorbed metal ions,
• Introduction of a chalcogen hydrogen-containing gas to react with the adsorbed metal ions,
wherein the process steps are repeated cyclically until a desired film thickness is obtained.

2. Method according to claim 1,
**characterised in that**
the solution of a metal compound is applied to the substrate by spraying.

3. Method according to claim 1,
**characterised in that**
the solution of a metal compound is applied by dipping the substrate in this solution.

4. Method according to claim 1,
**characterised in that**
TiO₂, CuInS₂, CuGaSe₂, chalcopyrites in general or glass are used as the substrate.

5. Method according to claim 1,
**characterised in that**
dissolved compounds of metals such as Cd, Cu, In, Pb, Ag, Sb or Bi, individually or as mixtures, which form poorly soluble metal chalcogenides in reaction with chalcogen hydrogens are used as the solution of a metal compound.

6. Method according to claim 1,
**characterised in that**
the metal compound is dissolved in a highly volatile solvent.

7. Method according to claim 6,
**characterised in that**
methanol, ethanol, acetonitrile or mixtures thereof are used as the solvent.

8. Method according to claim 1,
**characterised in that**
the metal compound is dissolved in water.

9. Method according to claim 1,
**characterised in that**
the moisture is removed by drying in a gas stream, preferably of inert gases such as e.g. noble gases or molecular nitrogen.

10. Method according to claim 1 and 8,
**characterised in that**
the moisture is removed by evaporation down to a defined residual moisture in the substrate.

11. Method according to claim 10,
**characterised in that**
the evaporation takes place during intermediate storage of the substrate covered with metal ions or during transport thereof.

12. Method according to claim 1,
**characterised in that**
the reaction gas contains the hydrogen compounds of the chalcogens S, Se or Te.

13. Method according to claim 1,
**characterised in that**
following the reaction, the coated substrate is rinsed in a solvent bath, preferably methanol, to remove excess reaction products.

14. Method according to claim 13,
**characterised in that**
the rinsing is followed by drying.

15. Arrangement for performing the method according to claim 1 to 12, comprising a substrate holder, a coverable reaction vessel and a vessel with a dissolved metal compound,
**characterised in that**
the vessel with the dissolved metal compound is designed as a dipping bath (5), next to the dipping bath (5) is arranged a drying vessel (6) through which a gas stream can flow and next to the drying vessel (6) is arranged a rinsing bath (8), the dipping bath (5), drying vessel (6), reaction vessel (7) and rinsing bath (8) being designed to be open at the top, and the substrate holder (2) is designed to be movable in all planes and can be inserted from above into the dipping bath (5), drying vessel (6), reaction vessel (7) and rinsing bath (8), wherein a cover (4) is permanently attached directly to the substrate holder (2) and when the substrate holder (2) is in the inserted state said cover forms a gas-tight seal on the reaction vessel (7).

## Revendications

1. °) Procédé pour produire des couches minces de chalcogénure métallique par exemple à utiliser comme couches d'absorbeur ou de tampon dans des cellules solaires à pression normale, où en fonction de la réactivité différente des métaux utilisés pour la formation de chalcogénure le regime des temperatures sera fixé différemment pour ce procédé, qui comprend les étapes suivantes:
- application d'une solution d'un composé métallique sur un substrat pour l'adsorption d'ions métalliques sans déclenchement d'une réaction chimique,
- extraction d'humidité hors du substrat avec les ions métalliques adsorbés,
- introduction d'un gaz contenant des hydrures de chalcogène pour la réaction avec les ions métalliques adsorbés,
et répétitions cycliques de ces étapes du procédé jusqu'à l'obtention de l'épaisseur de couche désirée.

2. °) Procédé selon la revendication 1,
**caractérisé en ce que**
l'application de la solution d'un composé métallique sur le substrat est effectuée par pulvérisation.

3. °) Procédé selon la revendication 1,
**caractérisé en ce que**
l'application de la solution d'un composé métallique est effectuée par immersion du substrat dans cette solution.

4. °) Procédé selon la revendication 1,
**caractérisé en ce que**
comme substrat on utilise du TiO₂, du CuInS₂, du CuGaSe₂, des chalcopyrites en général ou du verre.

5. °) Procédé selon la revendication 1,
**caractérisé en ce que**
comme solution d'un composé métallique on utilise des composés dissous de métaux tels que Cd, Cu, In, Pb, Ag, Sb ou Bi seuls ou en mélange qui, en réaction avec des hydrures de chalcogène, forment des chalcogénures métalliques difficilement solubles.

6. °) Procédé selon la revendication 1,
**caractérisé en ce que**
le composé métallique est dissous dans un solvant peu volatil.

7. °) Procédé selon la revendication 6,
**caractérisé en ce que**
comme solvant on utilise du méthanol, de l'éthanol, de l'acétonitrile ou des mélanges de ceux-ci.

8. °) Procédé selon la revendication 1,
**caractérisé en ce que**
le composé métallique est dissous dans l'eau.

9. °) Procédé selon la revendication 1,
**caractérisé en ce que**
l'extraction d'humidité est effectuée par séchage dans un courant de gaz, de préférence de gaz inertes comme par exemple des gaz rares ou de l'azote moléculaire.

10. °) Procédé selon les revendications 1 et 8,
**caractérisé en ce que**
l'extraction d'humidité est effectuée par évaporation jusqu'à une humidité résiduelle définie du substrat.

11. °) Procédé selon la revendication 10,
**caractérisé en ce que**
l'évaporation est effectuée lors du stockage intermédiaire du substrat revêtu d'ions métalliques ou lors du transport de celui-ci.

12. °) Procédé selon la revendication 1,
**caractérisé en ce que**
le gaz de réaction contient les composés hydrogénés des chalcogènes S, Se ou Te.

13. °) Procédé selon la revendication 1,
**caractérisé en ce qu'**
à la suite de la réaction, on effectue, un rinçage du substrat revêtu dans un bain de solvant, de préférence de méthanol, pour éliminer les produits de réaction excédentaires.

14. °) Procédé selon la revendication 13,
**caractérisé en ce que**
le rinçage est suivi d'un séchage.

15. °) Dispositif pour la mise en oeuvre du procédé selon les revendications 1 à 12, comportant un support de substrat, un récipient de réaction avec un couvercle et un récipient contenant un composé métallique dissous,
**caractérisé en ce que**
le récipient contenant le composant métallique dissous est un bain d'immersion (5), un récipient de séchage (6) pouvant être parcouru par un courant de gaz est disposé à côté du bain d'immersion (5) et un bain de rinçage (8) est disposé à côté du récipient de séchage (6), le bain d'immersion (5), le récipient de séchage (6), le récipient de réaction (7) et le bain de rinçage (8) sont ouverts vers le haut, et le support de substrat (2) est mobile sur tous les plans et peut être introduit par le haut dans le bain d'immersion (5), le récipient de séchage (6), le récipient de réaction (7) et le bain de rinçage (8), sachant qu'un couvercle (4) est fixé directement au support de substrat (2) et ferme le récipient de réaction (7) de façon étanche au gaz lorsque le support de substrat (2) est en position introduite.
